**Europäisches Patentamt**

**European Patent Office**

**Office européen des brevets**

(11) Numéro de publication: **0 197 801**
**A2**

# (12) DEMANDE DE BREVET EUROPEEN

(21) Numéro de dépôt: **86400090.6**

(22) Date de dépôt: **17.01.86**

(51) Int. Cl.⁴: **H 03 B 21/00**

(30) Priorité: **01.02.85 FR 8501403**

(43) Date de publication de la demande:
**15.10.86 Bulletin 86/42**

(84) Etats contractants désignés:
**AT BE CH DE FR GB IT LI NL SE**

(71) Demandeur: **ENERTEC**
**12 Place des Etats Unis**
**F-92120 Montrouge(FR)**

(72) Inventeur: **Pion, Francisque**
**La Feuilletière Bâtiment B Allée 1**
**F-42 390 Villars(FR)**

(74) Mandataire: **Bentz, Jean-Paul**
**GIERS SCHLUMBERGER Service BREVETS 12, place des**
**Etats-Unis**
**F-92124 Montrouge Cedex(FR)**

(54) Procédé et dispositif de calage en phase rapide d'un signal d'horloge.

(57) Procédé et dispositif, notamment pour la chronométrie, utilisant un signal d'horloge primaire sinusïdal et permettant de réduire l'incertitude de résolution temporelle à une valeur inférieure à la période du signal d'horloge.

Le dispositif comprend des échantillonneurs-bloqueurs (11), (12) dont chacun est susceptible d'être déclenché pour mémoriser la valeur prise, à l'instant de son déclenchement, par le signal d'horloge A(t) ou B(t).

Application à la chronométrie, à la synthèse et à l'analyse de signaux numériques.

FIG. 2

EP 0 197 801 A2

## PROCEDE ET DISPOSITIF DE CALAGE EN PHASE RAPIDE

## D'UN SIGNAL D'HORLOGE

La présente invention concerne un procédé et un dispositif pour délivrer un signal sinusoïdal de sortie à phase contrôlée, obtenu à partir de premier et second signaux sinusoïdaux d'entrée de même fréquence présentant une différence de phase non nulle, comprenant les étapes consistant à élaborer des premier et second signaux de référence représentés par des fonctions sinus respectives de deux angles de phase différents, à former des premier et second signaux hybrides, respectivement par multiplication du premier signal d'entrée avec le second signal de référence, et du second signal d'entrée avec le premier signal de référence, et à élaborer le signal de sortie comme une somme algébrique des deux signaux hybrides.

Un procédé de ce genre est par exemple décrit, comme appartenant à l'art antérieur, dans le brevet français n° 2 541 533 du 20 Février 1984, et plus précisément en référence à la figure 2 de ce brevet.

Ce procédé antérieur connu, qui permet d'introduire dans la phase d'un signal sinusoïdal un déphasage déterminé par réglage, fait usage d'un circuit de commande programmable destiné à délivrer des signaux de référence adoptant la forme de fonctions sinus et cosinus de l'angle qui représente ce déphasage déterminé. La valeur de cet angle est introduite dans le circuit sous la forme d'un paramètre réglable agissant sur le circuit de commande.

Ce procédé permet ainsi de produire un signal sinusoïdal de sortie dont la phase présente, à compter d'un instant déterminé, un déphasage de valeur déterminée par rapport à celle d'un signal sinusoïdal d'entrée, fourni par exemple

- 2 -                                          0197801

par un oscillateur à fréquence fixe.

Cependant, selon ce procédé de l'art antérieur, la phase du signal de sortie n'est connue, quel que soit l'instant considéré, que si la phase du signal d'entrée est elle-même connue à cet instant. Seule la différence entre ces deux phases est fixée à une valeur déterminée à compter d'un instant déterminé.

Bien que concernant également la production d'un signal sinusoïdal de sortie à phase contrôlée, dérivant d'un signal sinusoïdal d'entrée, la présente invention vise au contraire la production d'un signal sinusoïdal de sortie présentant une phase qui, à un instant déterminé, est fixée de façon absolue à une valeur déterminée.

A cette fin, le procédé de l'invention, qui comprend la multiplication des premier et second signaux sinusoïdaux d'entrée déphasés et de même fréquence avec des second et premier signaux de référence, est essentiellement caractérisé en ce que ces premier et second signaux de référence sont obtenus à partir d'un échantillonnage des premier et second signaux d'entrée, effectué à un instant de déclenchement choisi, le signal de sortie produit par combinaison des signaux issus des multiplications présentant ainsi, à cet instant de déclenchement, une phase de valeur prédéterminée, indépendante des angles de phase que présentent au même instant les signaux d'entrée.

Dans le cas où les premier et second signaux de référence sont directement constitués par les premier et second signaux d'entrée échantillonnés à l'instant de déclenchement, le signal de sortie est produit avec une phase nulle à cet instant de déclenchement.

- 3 -

0197801

Dans le cas où les premier et second signaux de référence sont obtenus par échantillonnage, audit instant de déclenchement, de premier et second signaux intermédiaires eux-mêmes obtenus respectivement par un déphasage, de valeur choisie, desdits premier et second signaux d'entrée, le signal de sortie est produit avec une phase ayant ladite valeur choisie audit instant de déclenchement.

De préférence, les signaux d'entrée sont en quatrature.

Le dispositif de l'invention, permettant de délivrer un signal sinusoïdal de sortie à phase contrôlée, et comprenant: des premier et second moyens pour délivrer des premier et second signaux sinusoïdaux d'entrée, déphasés et de même fréquence; des moyens pour élaborer des premier et second signaux de référence représentés par des fonctions sinus respectives de deux angles de phase différents; des premier et second mélangeurs pour former respectivement des premier et second signaux hybrides par multiplication du premier signal d'entrée avec le second signal de référence et du second signal d'entrée avec le premier signal de référence; et un sommateur pour élaborer le signal de sortie comme une somme algébrique des deux signaux hybrides, est essentiellement caractérisé en ce que lesdits moyens pour élaborer les premier et second signaux de référence comprennent respectivement des premier et second échantillonneurs-bloqueurs ayant des entrées de signaux respectivement reliées en permanence auxdits moyens pour délivrer des premier et second signaux d'entrée, des entrées de déclenchement respectives et des sorties respectives reliées aux mélangeurs respectifs, ces échantillonneurs-bloqueurs étant propres à reproduire sur leurs sorties respectives les signaux présents sur leurs entrées de signaux respectives à l'instant d'apparition d'une impulsion de déclenchement sur leurs entrées de

- 4 -

01978Q1

déclenchement respectives.

Ce dispositif peut comprendre une bascule bistable dont la sortie est reliée aux entrées de déclenchement desdits échantillonneurs-bloqueurs.

En outre, ce dispositif peut comporter des premier et second déphaseurs interposés entre lesdits échantillonneurs-bloqueurs et lesdits moyens pour délivrer lesdits signaux d'entrée, de sorte que le signal de sortie peut alors être produit avec, à l'instant du déclenchement, une phase de valeur choisie.

La présente invention comprend l'application d'au moins un échantillonneur-bloqueur susceptible d'être déclenché pour mémoriser la valeur prise à l'instant de déclenchement par un signal représenté par une fonction périodique du temps, par exemple par une fonction sinusoïdale.

La présente invention est en particulier utilisable pour le déclenchement d'un signal sinusoïdal d'horloge en synchronisme avec un phénomène indépendant de ce signal d'horloge, notamment dans les techniques de synthèse ou d'analyse numérique de signaux.

Un mode particulier de réalisation de l'invention sera décrit ci-après, à titre indicatif et nullement limitatif, en référence aux dessins annexés parmi lesquels :

- la figure 1 est un schéma de circuit illustrant l'art antérieur,

- la figure 2 est un schéma d'un mode de réalisation d'un circuit suivant l'invention,

- La figure 3 est un schéma d'un second circuit conforme à l'invention.

Le circuit de l'art antérieur comprend un oscillateur 1, délivrant un signal sinusoïdal d'entrée dont l'amplitude instantanée $A(t)$ est donnée en fonction du temps t par la relation :

$$A(t)=A_o.sin(w.t),$$

$A_o$ représentant l'amplitude maximale et w la pulsation du signal.

Ce signal sinusoïdal est transmis sur deux voies 2 et 3, dont l'une (voie 3) comporte en série un déphaseur 4 de gain d'unité déphasant le signal de -90°; ce déphaseur produit donc à sa sortie un second signal sinusoïdal, en quadrature avec le premier et dont l'amplitude instantanée $B(t)$ est donnée par la relation :

$$B(t)=A_o.cos(w.t)$$

Deux mélangeurs 5 et 6 sont respectivement disposés sur les deux voies 2 et 3, le mélangeur 6 étant relié à la sortie du déphaseur 4.

Outre les premier et second signaux d'entrée $A(t)$ et $B(t)$, les mélangeurs 5 et 6 reçoivent des signaux de référence D et C respectivement représentés par des fonctions cosinus et sinus d'un même angle de phase p, c'est-à-dire par exemple donnés par :

$$D=K.cos(p) \text{ et } C=K.sin(p)$$

où K est une constante.

Les mélangeurs 5 et 6, qui réalisent une multiplication des signaux d'entrée et de référence appliqués sur leur entrée, délivrent respectivement à leur sortie des signaux hybrides

$$E(t)=K.A_o.\sin(wt).\cos(p)$$

$$F(t)=K.A_o.\cos(wt).\sin(p)$$

Un amplificateur 7 est relié aux sorties des mélangeurs 5 et 6 de manière à recevoir sur ses entrées les signaux hybrides $E(t)$ et $F(t)$. Cet amplificateur 7, qui effectue une somme algébrique des signaux $E(t)$ et $F(t)$, par exemple une soustraction, délivre à sa sortie un signal combiné de sortie $A'(t)$ tel que :

$$A'(t)=E(t)-F(t)=K.A_o.\sin(wt-p)$$

Les signaux de référence C et D proviennent d'un circuit de commande 8 qui reçoit sur une entrée un signal de commande $S(p)$ sous forme analogique ou numérique et qui utilise ce signal $S(p)$ pour élaborer les signaux C et D représentés par des fonctions sinus et cosinus de l'angle de phase p, représentant le déphasage désiré entre les signaux d'entrée $A(t)$ et de sortie $A'(t)$.

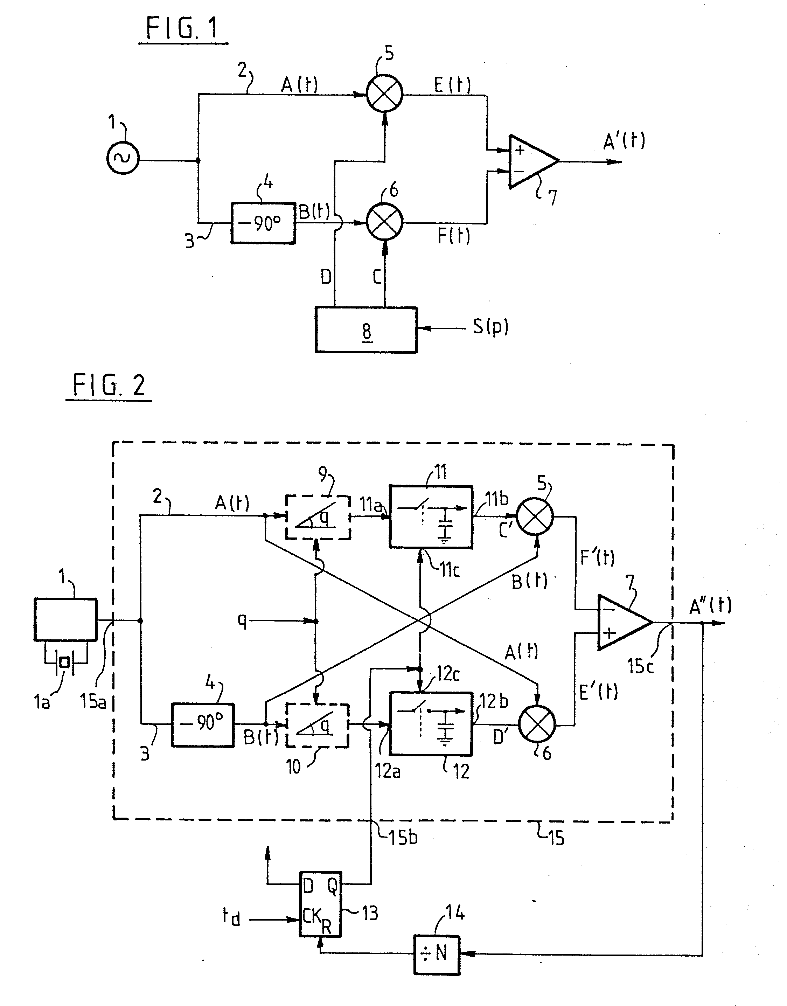

On remarquera que dans la description qui précède de l'art antérieur illustré par la figure 1, les signaux $A(t)$ et $B(t)$ sont dits en quadrature, et les signaux de référence C et D sont dits être représentés par des fonctions sinus et cosinus d'un même angle de phase p.

Ceci correspond en fait à un fonctionnement optimal du circuit de la figure 1, sans toutefois correspondre à un ensemble de conditions strictement nécessaires.

Il suffit en effet, pour que le circuit de la figure 1 remplisse sa fonction, que les signaux d'entrée A(t) et B(t) soient des signaux sinusoïdaux de même fréquence présentant une différence de phase d non nulle, et que les signaux hybrides C et D soient représentés par des fonctions sinus de deux angles de phase différant entre eux de la valeur d; par exemple : $A(t)=A_O.\sin(wt)$

$$B(t)= A_O.\sin(wt+d)$$
$$C = K.\sin(p)$$
$$D = K.\sin(p+d)$$

En d'autres termes, le déphasage d'entre A(t) et B(t) d'une part, C et D d'autre part, est de préférence égal à 90°, mais non nécessairement égal à cette valeur.

Cette remarque, qui vaut pour l'invention, sera implicite dans la description qui va suivre et qui, pour des raisons de commodité, ne considérera que le cas où les signaux d'entrée sont en quadrature.

La figure 2 est un schéma d'un mode de réalisation d'un circuit suivant l'invention; les éléments apparaissant sur les figures 1 et 2 avec les mêmes signes de référence remplissent des fonctions équivalentes.

Ce circuit comprend une source 1 de signal sinusoïdal d'horloge, par exemple constitué par un oscillateur stabilisé par un résonateur à quartz la. Le signal sinusoïdal A(t), de fréquence éventuellement élevée, par exemple 20MHz, est délivré sur deux voies 2 et 3 et parvient, sur la voie 3 à un déphaseur 4 de gain unité qui le déphase de -90° et fournit un signal sinusoïdal $B(t)=A_O.\cos(w.t)$.

Les signaux A(t) et B(t) sont appliqués, directement ou par l'intermédiaire de déphaseurs 9 et 10 comme il sera décrit ultérieurement, sur des entrées de signaux 11a, 12a d'échantillonneurs-bloqueurs respectifs 11 et 12.

Chacun de ces échantillonneurs-bloqueurs, identiques et connus dans leur fonction, a pour rôle de délivrer sur sa sortie (respectivement 11b, 12b), pendant un intervalle de temps aussi long que nécessaire, un signal de sortie ayant l'amplitude du signal présent à son entrée de signal (respectivement 11a, 12a), à l'instant d'apparition d'une impulsion de déclenchement appliquée sur une entrée de déclenchement (respectivement 11c, 12c) de ce même échantillonneur-bloqueur. Ces entrées de déclenchement 11c, 12c, sont reliées à la sortie Q d'une bascule bistable 13, de sorte que les échantillonneurs-bloqueurs 11, 12 sont susceptibles d'être déclenchés simultanément par cette bascule.

Ainsi, si les déphaseurs 9 et 10 sont absents ou inopérants, et si l'impulsion de déclenchement intervient à un instant $t_d$, l'échantillonneur-bloqueur 11 délivre à partir de cet instant un signal de référence $C'=A(t_d)=A_o.\sin(w.t_d)$ et l'échantillonneur-bloqueur 12 délivre un signal de référence $D'=B(t_d)=A_o.\cos(w.t_d)$.

Le mélangeur 5, recevant les signaux B(t) et C', délivre un signal $F'(t)=A_o^2\cos(w.t).\sin(w.t_d)$ et le mélangeur 6, recevant les signaux A(t) et D', délivre un signal $E'(t)=A_o^2.\sin(w.t).\cos(w.t_d)$.

L'amplificateur 7, recevant les signaux E'(t) et F'(t), produit par différence un signal de sortie $A''(t)=E'(t)-F'(t)=A_o^2.\sin(w.t-w.t_d)$ qui, à l'instant de déclenchement $t_d$, présente un angle de phase nul.

Comme le montre la figure 2, des déphaseurs 9 et 10, réglables ou non, peuvent être placés sur les voies 2 et 3 en amont des échantillonneurs-bloqueurs 11 et 12 de manière à délivrer aux entrées respectives 11a et 12a de ces derniers des signaux intermédiaires $A_q(t)$ et $B_q(t)$ déphasés d'un angle q par rapport aux signaux d'entrée $A(t)$ et $B(t)$.

Dans ce cas, les signaux $A_q(t)$ et $B_q(t)$ répondant aux relations : $A_q(t)=A_o.\sin(wt+q)$ et $B_q(t)=A_o.\cos(wt+q)$, les signaux de référence C' et D' susceptibles d'être délivrés par les échantillonneurs-bloqueurs 11 et 12 à un instant de déclenchement $t_d$ prennent la forme $C'_q=A_o.\sin(w.t_d+q)$ et $D'_q=A_o.\cos(w.t_d+q)$.

L'amplificateur de sortie 7 fournit alors un signal de sortie $A''_q=A_o^2.\sin(w.t-w.t_d-q)$ qui, à l'instant de déclenchement $t_d$, présente un angle de phase égal à -q.

Les déphaseurs 9 et 10, doivent avoir des effets identiques et synchronisés sur les deux signaux d'entrée.

Néanmoins, même lorsqu'ils sont susceptibles d'être commandés, ces déphaseurs n'ont pas nécessairement besoin de présenter un temps de réponse très court par rapport à leur commande; en outre ils agissent sur les signaux $A(t)$ et $B(t)$ de fréquence fixe; ces déphaseurs peuvent donc être constitués par des déphaseurs relativement simples de l'art antérieur, commandés simultanément.

La bascule bistable 13 est par exemple elle-même déclenchée par une impulsion sur son entrée d'horloge CK et remise à zéro par le signal de sortie d'un diviseur de fréquence 14 recevant le signal de sortie $A''(t)$, de manière à pouvoir, après avoir été déclenchée une première fois, être déclenchée à nouveau au bout d'un intervalle de temps correspondant à l'apparition d'un nombre N de périodes du signal A*(t), fixé par le diviseur de fréquence 14. Un filtre passe-haut (non représenté) peut être monté à la sortie de l'amplificateur 7 pour améliorer la pureté spectrale du signal de sortie A*(t).

L'invention est notamment utilisable pour synthétiser un signal d'horloge déclenché en synchronisme avec l'apparition d'un phénomène quelconque, à partir d'un signal d'horloge initial avec lequel l'apparition de ce phénomène est totalement asynchrone.

En particulier, les techniques de synthèse et d'analyse numérique des signaux utilisent toujours une horloge dont chaque période représente une référence de temps.

Si par exemple, une opération doit être effectuée au bout d'un intervalle de temps déterminé à compter de l'apparition d'un phénomène physique, et si cet intervalle de temps est mesuré en comptant le nombre de passages à zéro d'un signal d'horloge, il est nécessaire que le début du comptage coïncide avec un passage à zéro du signal d'horloge, c'est-à-dire que ce dernier soit produit avec une phase nulle (ou égale à 180°) à l'instant d'apparition du phénomène physique concerné. Ceci peut être obtenu, grâce à l'invention, en déclenchant la bascule 13 par une impulsion de déclenchement produite à l'instant $t_d$ où le phénomène physique apparaît.

Pour la suite de la description, l'ensemble des éléments 2 à 12c de la figure 2 sera désigné comme un circuit de mise en phase rapide, portant la référence 15.

Ce circuit 15 comporte une entrée d'horloge 15a reliée à la sortie de l'oscillateur 1, une entrée de déclenchement 15b reliée, sur la figure 2, à la bascule 13, et une sortie 15c.

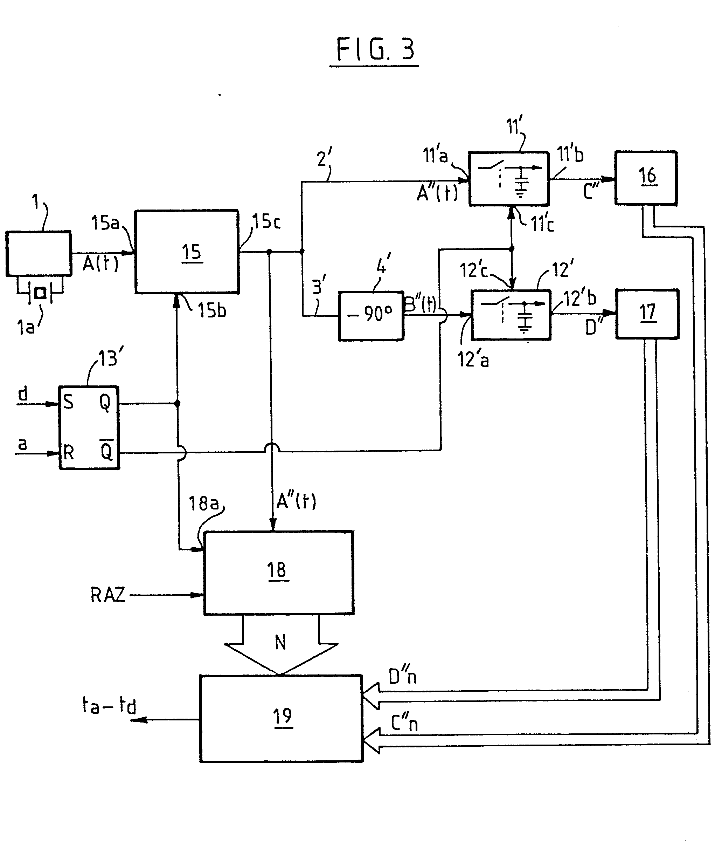

La figure 3 représente un montage utilisant le circuit de mise en phase 15 et permettant de mesurer avec précision la durée d'un phénomène; les éléments apparaissant sur les figures 2 et 3 avec les mêmes signes de référence remplissent des fonctions équivalentes.

Le début du phénomène, dont la durée est à mesurer, est indiqué au circuit sous la forme d'un signal de mise en marche "d" appliqué à l'entrée de déclenchement S (set) d'une bascule bistable RS 13' et la fin du phénomène est marquée par l'apparition d'un signal d'arrêt "a" appliqué à l'entrée de remise à zéro R (reset) de cette bascule 13'.

Le signal de sortie Q de la bascule 13, au niveau logique haut pendant la durée du phénomène, est appliqué d'une part à l'entrée de déclenchement 15b du circuit de mise en phase rapide 15, et d'autre part à une entrée de validation de comptage 18a d'un compteur 18.

Le circuit 15 reçoit sur son entrée 15a un signal d'horloge sinusoïdal primaire A(t) en provenance de l'oscillateur stabilisé 1 et produit sur sa sortie 15c un signal d'horloge sinusoïdal secondaire A''(t) qui, à l'instant du déclenchement du circuit 25 par le signal "d" à travers la bascule 13', présente par exemple un angle de phase nul.

Pendant toute la durée du phénomène, c'est-à-dire pendant tout le temps que le signal de sortie Q de la bascule 13' est au niveau haut, le compteur 18 compte les périodes entières successives du signal $A''(t) = A_o^2 . \sin w(t-td)$.

Le nombre entier de ces périodes sera désigné par N.

Le signal d'horloge secondaire A"(t) est également appliqué sur deux voies 2' et 3' sur lesquelles sont montés respectivement un échantillonneur-bloqueur 11' d'une part et un · déphaseur 4' suivi en série d'un échantillonneur-bloqueur 12' d'autre part.

Les éléments 4', 11' et 12' sont tout à fait équivalents aux éléments 4, 11 et 12 précédemment décrits.

Les échantillonneurs-bloqueurs 11' et 12' sont susceptibles d'être déclenchés par un signal NON Q (Q barre) appliqué par la bascule 13' sur leurs entrées 11'c et 12'c respectives, ce signal NON Q apparaissant en synchronisme avec le signal "a" marquant la fin du phénomène à étudier.

Il en résulte que les échantillonneurs-bloqueurs 11' et 12' délivrent sur leurs sorties respectives 11'b et 12'b, après la disparition du phénomène, des signaux en quadrature C" et D" respectivement proportionnels à $\sin w (t_a - t_d)$ et à $\cos w(t_a - t_d)$, où $t_a$ désigne l'instant d'apparition du signal a, c'est-à-dire la fin du phénomène.

Les signaux analogiques C" et D" sont transmis à des convertisseurs analogique-numérique respectifs 16, 17 qui les transforment en signaux numériques respectifs $C"_n$ et $D"_n$, eux aussi respectivement représentatifs de $\sin w(t_a - t_d)$ et de $\cos w(t_a - t_d)$.

Les signaux numériques N, $C"_n$ et $D"_n$ sont transmis à une unité de calcul 19 qui, sur la base de relations mathématiques bien connues, en déduit la valeur $t_a - t_d$ de la durée du phénomène observé.

Le montage de la figure 3 fait apparaître, comme le circuit de la figure 2, l'application, à la chronométrie, d'échantillonneurs-bloqueurs 11, 12, 11', 12' dont chacun est susceptible d'être déclenché pour mémoriser la valeur prise, à l'instant de son déclenchement, par un signal, tel que A(t), B(t), A"(t), B"(t), représenté par une fonction périodique du temps, en particulier par une fonction sinusoïdale. Dans les deux cas, l'emploi de ces échantillonneurs-bloqueurs permet de réduire une incertitude de résolution temporelle à une valeur sensiblement inférieure à la période d'un signal d'horloge tel que A(t), B(t), A"(t), B"(t).

REVENDICATIONS

1. Procédé pour délivrer un signal sinusoïdal de sortie (A"(t)) à phase contrôlée, obtenu à partir de premier et second signaux sinusoïdaux d'entrée de même fréquence (A(t), B(t)) présentant une différence de phase non nulle, comprenant les étapes consistant à élaborer des premier et second signaux de référence (C', D') représentés par des fonctions sinus respectives de deux angles de phase différents, à former des premier et second signaux hybrides (E'(t), F'(t)) respectivement par multiplication du premier signal d'entrée avec le second signal de référence, et du second signal d'entrée avec le premier signal de référence, et à élaborer le signal de sortie (A"(t)) comme une somme algébrique des deux signaux hybrides (E'(t), F'(t)), caractérisé en ce que lesdits premier et second signaux de référence (C', D') sont obtenus à partir d'un échantillonnage des premier et second signaux d'entrée, effectué à un instant de déclenchement ($t_d$) choisi, ledit signal de sortie ainsi produit présentant, à cet instant de déclenchement, une phase de valeur prédéterminée, indépendante des angles de phase que présentent au même instant les signaux d'entrée.

2. Procédé suivant la revendication 1, caractérisé en ce que les premier et second signaux de référence sont directement constitués par les premier et second signaux d'entrée ($A(t_d)$, $B(t_d)$) échantillonnés à l'instant de déclenchement, ledit signal de sortie étant ainsi produit avec une phase nulle à cet instant.

3. Procédé suivant la revendication 1, caractérisé en ce que les premier et second signaux de référence sont obtenus par échantillonnage, audit instant de déclenchement, de premier et second signaux intermédiaires ($A_q(t)$, $B_q(t)$), eux-mêmes obtenus respectivement par un déphasage (q), de valeur choisie, desdits premier et second signaux d'entrée, le signal de sortie étant ainsi produit avec une phase (q) ayant ladite valeur choisie audit instant de déclenchement.

4. Procédé suivant l'une quelconque des revendications 1 à 3, caractérisé en ce que lesdits signaux d'entrée sont en quadrature.

5. Dispositif pour délivrer un signal sinusoïdal de sortie à phase contrôlée, comprenant des premier et second moyens (1, 4) pour délivrer des premier et second signaux sinusoïdaux d'entrée ($A(t)$, $B(t)$) de même fréquence présentant une différence de phase non nulle, des moyens pour élaborer des premier et second signaux de référence ($C'$, $D'$) respectivement représentés par des fonctions sinus de deux angles de phase différents; des premier et second mélangeurs (6, 5) pour former des premier et second signaux hybrides ($E'(t)$, $F'(t)$) respectivement par multiplication du premier signal d'entrée avec le second signal de référence et du second signal d'entrée avec le premier signal de référence; et un sommateur (7) pour élaborer le signal de sortie ($A''(t)$) comme une somme algébrique des deux signaux hybrides, caractérisé en ce que lesdits moyens pour élaborer des premier et second signaux de référence comprennent respectivement des premier et second échantillonneurs-bloqueurs (11, 12) ayant des entrées de signaux (11a, 12a) respectivement reliées en permanence auxdits moyens pour délivrer des premier et second signaux d'entrée, des entrées de déclenchement respectives (11c, 12c) et des sorties respectives (11b,

12b) reliées aux mélangeurs respectifs, ceséchantillonneurs-bloqueurs étant propres à reproduire . sur leurs sorties respectives les signaux présents sur leurs entrées de signaux respectives à l'instant d'apparition d'une impulsion de déclenchement sur leurs entrées de déclenchement respectives.

6. Dispositif suivant la revendication 5, caractérisé en ce qu'il comprend une bascule bistable (13) dont la sortie est reliée aux entrées de déclenchement desdits échantillonneurs-bloqueurs.

7. Dispositif suivant la revendication 5 ou 6, caractérisé en ce qu'il comporte des premier et second déphaseurs (9, 10) interposés entre lesdits moyens pour délivrer lesdits signaux d'entrée et lesdits échantillonneurs-bloqueurs.

8. Dispositif suivant l'une quelconque des revendications 5 à 7, caractérisé en ce que lesdits premier et second moyens pour délivrer des premier et second signaux d'entrée délivrent des signaux en quadrature.

9. Application, à la chronométrie, d'un échantillonneur-bloqueur susceptible d'être déclenché pour mémoriser la valeur prise, à l'instant de son déclenchement, par un signal représenté par une fonction périodique du temps.

10. Application suivant la revendication 9, caractérisé en ce que ladite fonction périodique est une fonction sinusoïdale.

FIG. 1

FIG. 2

# FIG. 3